# EUROPEAN PATENT SPECIFICATION

(11) **EP 3 744 788 B1**
(45) Date of publication and mention of the grant of the patent: **10.01.2024**
(21) Application number: 17936498.9
(22) Date of filing: 29.12.2017
(51) Int. Cl.: C08L 63/00, C08L 79/08

(54) **RESIN COMPOSITION, PREPREG, LAMINATE, AND METAL FOIL-COATED LAMINATE**
HARZZUSAMMENSETZUNG, PREPREG, LAMINAT UND METALLFOLIENBESCHICHTETES LAMINAT
COMPOSITION DE RÉSINE, PRÉIMPRÉGNÉ, STRATIFIÉ ET STRATIFIÉ REVÊTU D'UNE FEUILLE MÉTALLIQUE

(43) Date of publication of application: 02.12.2020
(73) Proprietor: Shengyi Technology Co., Ltd, Dongguan, Guangdong 523808 (CN)
(72) Inventor: TANG, Junqi, Dongguan, Guangdong 523808 (CN); LI, Zhiguang, Dongguan, Guangdong 523808 (CN)
(74) Representative: Gill Jennings & Every LLP
(86) International application number: PCT/CN2017/119902
(87) International publication number: WO 2019/127388

(56) References cited:
- EP-A1- 2 657 295
- CN-A- 102 115 600
- CN-A- 103 074 026
- CN-A- 108 239 372
- KR-A- 20150 037 685
- US-A1- 2016 369 099

## Description

### TECHNICAL FIELD

The present invention relates to the technical field of packaging for electronic products, in particular to a resin composition and a prepreg, laminate and metal foil-clad laminate prepared using the same.

### BACKGROUND

With the development of packaging forms, the packaging density is getting higher and higher, such as POP packaging (package stacking technology), MCP packaging (multi-chip packaging), and the requirements for the coefficient of thermal expansion (CTE) and rigidity of the packaging substrate are getting higher and higher. For a package with a single package form, such as BGA package (ball grid array package), package substrates having low XY CTE and high rigidity can show the effect of reducing warpage. EP2657295A1 and US2016/369099A1 disclose compositions for prepregs comprising an epoxy resin, a cyanate ester resin, a bismaleimide resin.

For a package with a complicated package shape, the warpage requirements for different parts are different due to its fixedness, which is obviously not applicable. At the same time, the thermal stress generated by the chip and other components during the installation process cannot be alleviated, and the soldered parts are prone to cracking, so as to make the circuit ineffective.

### SUMMARY

Due to the requirement of low warpage, low coefficient of thermal expansion and high rigidity are required for packaging substrates. As the packaging density becomes higher and higher, it has become a trend that the coefficient of thermal expansion becomes lower and lower and the rigidity gets higher and higher. For a package with a single package form, it can show the effect of reducing warpage. But for a package with a complex package form, it is obviously not applicable due to its fixedness. At the same time, the thermal stress generated by the chip and other components during the installation process cannot be alleviated, and the soldered parts are prone to cracking, so as to make the circuit ineffective.

In addition, the package substrate is easy to absorb moisture under high temperature and high humidity. During the high temperature processing, the evaporation of water leads to voids between a resin and a resin, between a resin and a base material, and between a resin and a metal foil, resulting in circuit failure. The continuous increase in the ambient temperature places higher requirements on the heat resistance of the package substrate.

The object of the present invention is to provide a resin composition. The prepreg, laminate and metal foil-clad laminate prepared using the resin composition have a low coefficient of thermal expansion in X and Y directions and modulus and, at the same time, have good heat resistance and heat and humidity resistance.

In order to achieve the above object, the present invention adopts the following technical solutions.

One aspect of the present invention provides a resin composition containing an epoxy resin (A), a cyanate ester resin (B), a bismaleimide resin (C), a high-molecular-weight resin (D) having structures represented by Formula (1), Formula (2), Formula (3) and Formula (4) and a weight-average molecular weight of 100,000-200,000, and an inorganic filler (E), 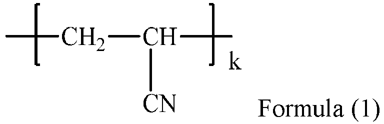 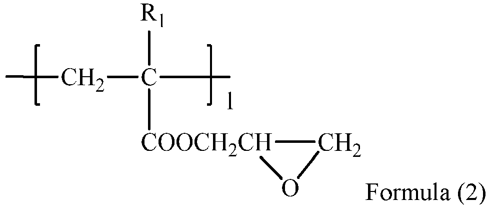 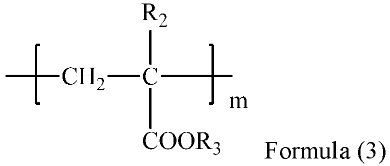 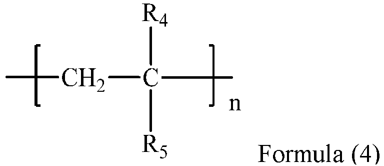 wherein k, l, m and n are molar fractions, where k + l + m + n≤1; 0≤k≤0.30; 0.01≤l≤0.20; 0.10≤m≤0.60; 0≤n≤0.60; in Formula (2), R₁ is a hydrogen atom or an alkyl group having 1-8 carbon atoms; in Formula (3), R₂ and R₃ are each independently a hydrogen atom or an alkyl group having 1-8 carbon atoms; in Formula (4), R₄ is a hydrogen atom or an alkyl group having 1-8 carbon atoms; R₅ is Ph (phenyl), -COO(CH₂)₂Ph or -COOCH₂Ph wherein the epoxy value of the high-molecular-weight resin (D) is in the range of 0.10 eq/kg to 0.80 eq/kg.

Optionally, R₁ is a hydrogen atom or a methyl group; R₂ is a hydrogen atom or a methyl group; R₃ is an alkyl group having 1-8 carbon atoms; R₄ is a hydrogen atom or a methyl group.

Optionally, the high-molecular-weight resin (D) is in an amount of 5 to 60% by mass of the total content 100% by mass of the epoxy resin (A), cyanate ester resin (B) and bismaleimide amine resin (C).

Optionally, the epoxy value of the high-molecular-weight resin (D) is in the range of 0.35 eq/kg~0.70 eq/kg, further preferably 0.40 eq/kg~0.65 eq/kg.

Optionally, the epoxy resin (A) is in an amount of 20 to 80%, preferably 30-70%, further preferably 40-60%, by mass of the total content 100% by mass of the epoxy resin (A), cyanate ester resin (B), and bismaleimide amine resin (C).

Optionally, the cyanate ester resin (B) is in an amount of 15 to 70%, preferably 20-60%, further preferably 20-50%, by mass of the total content 100% by mass of the epoxy resin (A), cyanate ester resin (B), and bismaleimide amine resin (C).

Optionally, the bismaleimide amine resin (C) is in an amount of 5 to 50%, preferably 10-40%, by mass of the total content 100% by mass of the epoxy resin (A), cyanate ester resin (B), and bismaleimide amine resin (C).

Optionally, the inorganic filler (E) is in an amount of 10 to 300%, preferably 30-270%, further preferably 50-250%, by mass of the total content 100% by mass of the epoxy resin (A), cyanate ester resin (B), and bismaleimide amine resin (C).

Another aspect of the present invention provides a prepreg comprising a substrate and the resin composition attached thereon by impregnation or coating.

Another aspect of the present invention provides a laminate comprising at least one prepreg above.

Another aspect of the present invention provides a metal foil-clad laminate comprising at least one prepreg above and a metal foil(s) coated on one or both sides of the prepreg(s).

Effects of the invention: The resin composition provided by the present invention has the advantages of good heat resistance, heat and humidity resistance, and low coefficient of thermal expansion and modulus. The prepregs, laminates, and metal foil-clad laminates prepared using the resin composition have good heat resistance, humidity and heat resistance, and low coefficient of thermal expansion and modulus, which helps reduce the warpage of package carrier boards and is suitable for packaging packages with various forms.

### DETAILED DESCRIPTION

In order to better explain the present invention, some specific embodiments of the present invention will be described in detail. However, the embodiments of the present invention are not limited to these embodiments, and various modifications can be made within the scope of the claims.

### -Resin composition-

The resin composition of the present invention contains an epoxy resin (A), a cyanate ester resin (B), a bismaleimide resin (C), a high-molecular-weight resin (D) and an inorganic filler (E), as well as an optional accelerator (F) and other additives. Hereinafter, each component will be described in detail.

### Epoxy resin (A)

The epoxy resin (A) is a matrix resin in the resin composition of the present invention, which is selected from organic compounds containing at least two epoxy groups in the molecular structure, and may be any one or a mixture of at least two selected from the group consisting of bisphenol A epoxy resin, bisphenol F epoxy resin, linear novolac epoxy resin, cresol novolac epoxy resin, bisphenol A novolac epoxy resin, tetramethyl bisphenol F epoxy resin, bisphenol M epoxy resin, bisphenol S epoxy resin, bisphenol E epoxy resin, bisphenol P epoxy resin, trifunctional phenol epoxy resin, tetrafunctional phenol epoxy resin, naphthalene epoxy resin, naphthol epoxy resin, naphthol novolac epoxy resin, anthracene epoxy resin, phenolphthalein epoxy resin, phenoxy epoxy resin, norbornene epoxy resin, adamantane epoxy resin, fluorene epoxy resin, biphenyl epoxy resin, dicyclopentadiene epoxy resin, dicyclopentadiene novolac epoxy resin, aralkyl epoxy resin, aralkyl novolac epoxy resin, epoxy resin containing arylene ether structure in the molecule, alicyclic epoxy resin, polyol epoxy resin, silicon-containing epoxy resin, nitrogen-containing epoxy resin, phosphorus-containing epoxy resin, glycidyl amine epoxy resin and glycidyl ester epoxy resin.

In order to make the resin composition have higher heat resistance and flame retardancy and lower coefficient of thermal expansion, the epoxy resin of the present invention is further preferably any one or a mixture of at least two selected from the group consisting of linear novolac epoxy resin, cresol novolac epoxy resin, naphthol epoxy resin, naphthol novolac epoxy resin, anthracene epoxy resin, phenolphthalein epoxy resin, biphenyl epoxy resin, aralkyl epoxy resin, aralkyl novolac epoxy resin and epoxy resin containing an arylene ether structure in the molecule, particularly preferably any one or a mixture of at least two selected from the group consisting of linear novolac epoxy resin, cresol novolac epoxy resin, naphthol novolac epoxy resin, anthracene epoxy resin, phenolphthalein epoxy resin, aralkyl novolac epoxy resin and epoxy resin containing an arylene ether structure in the molecule.

In particular, if the epoxy resin (A) has at least a biphenyl-type epoxy resin having the structure represented by Formula (5), in order to prevent the resin composition in a varnish state from being affected by resin precipitation and the like, the biphenyl-type epoxy resin having the structure shown in Formula (5) is in an amount of 0 to 80% by mass, preferably 0 to 60% by mass of the total content 100% by mass of the epoxy resin.

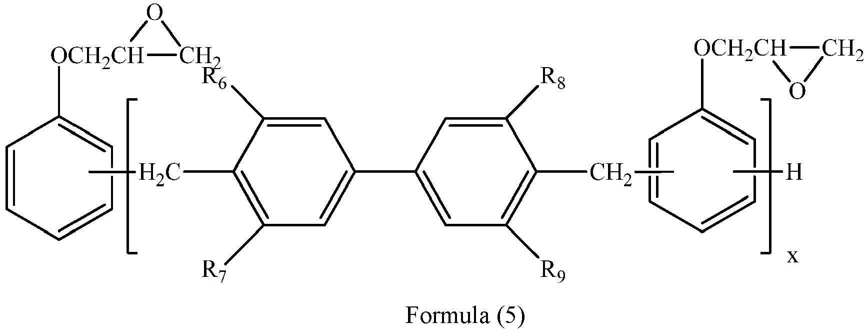

In Formula (5), R₆, R₇, R₈ and R₉ are each independently a hydrogen atom, or a substituted or unsubstituted linear or branched alkyl group having 1 to 5 carbon atoms; and x is an integer of 20 or less.

The epoxy resin (A) in the resin composition is in an amount of 20 to 80%, preferably 30-70%, further preferably 40-60%, by mass of the total content 100% by mass of the epoxy resin (A), cyanate ester resin (B), and bismaleimide amine resin (C), which can ensure the resin composition has better processability, but not excessively reduce the rigidity and heat resistance of the resin composition

### Cyanate ester resin (B)

The cyanate ester resin (B) is a thermosetting resin component in the resin composition of the present invention, and is used in combination with the epoxy resin (A) to improve the adhesion of the resin composition, especially the adhesion to metal foil, heat resistance and dielectric properties. The content of the cyanate ester resin (B) in the resin composition is defined. Optionally, the cyanate ester resin (B) is in an amount of 15 to 70%, preferably 20 to 60%, and more preferably 20 to 50%, by mass of the total content 100% by mass of the epoxy resin (A), cyanate ester resin (B), and bismaleimide amine resin (C). If the content of the cyanate ester resin is higher than 70% by mass, the water absorption rate of the laminate is increased, and the humidity and heat resistance is deteriorated due to the introduction of the polar group, *i.e.,* the cyanate ester group. If the content of the cyanate ester resin is less than 15% by mass, the dielectric properties of the laminate decrease, and the glass transition temperature decreases due to the decrease of the content of triazine ring which is a self-polymerization product of cyanate ester groups.

The cyanate ester resin (B) may be selected from cyanate monomers or cyanate prepolymers containing at least two cyanate groups in the molecular structure, preferably any one or a mixture of at least two selected from the group consisting of bisphenol A cyanate ester resin, bisphenol F cyanate ester resin, bisphenol M cyanate ester resin, bisphenol S cyanate ester resin, bisphenol E cyanate ester resin, bisphenol P cyanate ester resin, linear novolac cyanate ester resin, naphthol cyanate ester resin, naphthol novolac cyanate ester resin, dicyclopentadiene cyanate ester resin, aralkyl cyanate ester resin, aralkyl novolac cyanate ester resin, bisphenol A cyanate prepolymer, bisphenol F cyanate prepolymer, bisphenol M cyanate prepolymer, bisphenol S cyanate prepolymer, bisphenol E cyanate prepolymer, bisphenol P cyanate prepolymer, linear novolac cyanate prepolymer, naphthol cyanate prepolymer, naphthol phenol cyanate prepolymer, dicyclopentadiene cyanate prepolymer, aralkyl cyanate prepolymer and aralkyl novolac cyanate prepolymer.

### Bismaleimide resin (C)

In the resin composition of the present invention, the bismaleimide resin (C) mainly serves to make the laminate resin composition more excellent in mechanical properties, heat resistance, and coefficient of thermal expansion in the planar direction.

The maleimide compound described in the present invention is not particularly limited, and may be selected from compounds containing at least one maleimide group in the molecular structure, preferably compounds containing at least two maleimide groups in the molecular structure, further preferably any one or a mixture of at least two selected from the group consisting of N-phenylmaleimide, N-(2-methylphenyl)maleimide, N-(4-methylphenyl)maleimide, N-(2,6-dimethylphenyl)maleimide, bis(4-maleimidophenyl)methane, 2,2-bis(4-(4-maleimidophenoxy)-phenyl)propane, bis(3,5-dimethyl-4-maleimidophenyl)methane, bis(3-ethyl-5-methyl-4-maleimidophenyl)-methane, bis(3,5-diethyl-4-maleimidophenyl)methane, polyphenylmethane-bismaleimide, maleimide with biphenyl structure, N-phenylmaleimide prepolymer, N-(2-methylphenyl)maleimide prepolymer, N-(4-methylphenyl)maleimide prepolymer, N-(2,6-dimethylphenyl)maleimide prepolymer, bis(4-maleimidophenyl)methane prepolymer, 2,2-bis(4-(4-maleimidophenoxy)-phenyl)propane prepolymer, bis(3,5-dimethyl-4-maleimidophenyl)methane prepolymer, bis(3-ethyl-5-methyl-4-maleimidophenyl)methane prepolymer, bis(3,5-diethyl-4-maleimidophenyl)methane prepolymer, polyphenylmethanebismaleimide prepolymer, maleimide prepolymer containing biphenyl structure, prepolymer of N-phenylmaleimide and amine compounds, prepolymers of N-(2-methylphenyl)maleimide and amine compounds, prepolymers of N-(4-methylphenyl)maleimide and amine compounds, prepolymers of N-(2,6-dimethylphenyl)maleimide and amine compounds, prepolymers of bis(4-maleimidophenyl)methane and amine compounds, prepolymers of 2,2-bis(4-(4-maleimidophenoxy)-phenyl)propane and amine compounds, prepolymers bis(3,5-dimethyl-4-maleimidophenyl)methane and amine compounds, prepolymers bis(3-ethyl-5-methyl-4-maleimidophenyl)methane and amine compounds, prepolymers of bis(3,5-diethyl-4-maleimidophenyl)methane and amine compounds, prepolymers of maleimide containing biphenyl structure and amine compounds, and prepolymers of polyphenylmethanebismaleimide and amine compounds, most preferably any one or a mixture of at least two selected from the group consisting of bis(4-maleimidophenyl)methane, 2,2-bis(4-(4-maleimidophenoxy)-phenyl)propane, maleimide containing biphenyl structure, polyphenylmethanebismaleimide or bis(3-ethyl-5-methyl-4-maleimidophenyl)-methane, and maleimide containing biphenyl structure.

Bismaleimide (C) is in an amount of 5-50%, preferably 10-40%, by mass of the total content 100% by mass of the epoxy resin (A), cyanate ester resin (B) and bismaleimide resin (C).

### High-molecular-weight resin (D)

The high-molecular-weight resin (D) is an epoxy-modified acrylate resin, which mainly functions as a low-elasticity resin component in the resin composition of the present invention. Specifically, the high-molecular-weight resin (D) is the resin having structures represented by Formula (1), Formula (2), Formula (3) and Formula (4) and a weight-average molecular weight of 100,000-200,000. 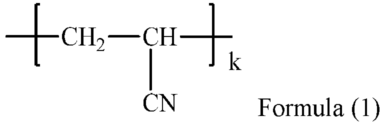 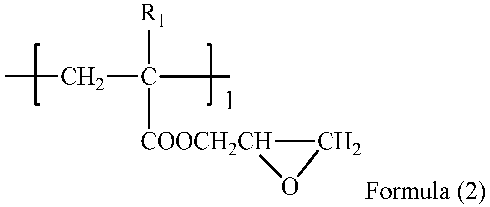 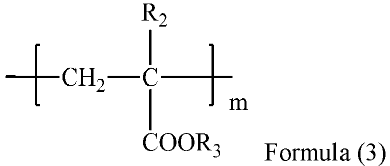 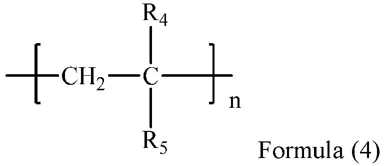 wherein k, l, m and n are molar fractions, where k + l + m + n≤1; 0≤k≤0.30; 0.01≤l≤0.20; 0.10≤m≤0.60; 0≤n≤0.60; in Formula (2), R₁ is a hydrogen atom or an alkyl group having 1-8 carbon atoms; in Formula (3), R₂ and R₃ are each independently a hydrogen atom or an alkyl group having 1-8 carbon atoms; in Formula (4), R₄ is a hydrogen atom or an alkyl group having 1-8 carbon atoms; R₅ is Ph (phenyl) or -COOCH₂Ph or -COOCH₂CH₂Ph.

Optionally, R₁ is a hydrogen atom or a methyl group; R₂ is a hydrogen atom or a methyl group; R₃ is an alkyl group having 1-8 carbon atoms; R₄ is a hydrogen atom or a methyl group.

In the high-molecular-weight resin (D) having the structures of Formula (1), Formula (2), Formula (3) and Formula (4), the order of the structures of Formula (1), Formula (2), Formula (3) and Formula (4) is not limited. The structures of Formula (1), Formula (2), Formula (3) and Formula (4) may or may not be continuous.

The structure of Formula (1) in high-molecular-weight resin (D) contains a cyano group, which can react with cyanate ester resin (B) and bismaleimide resin (C) under high temperature reaction. The introduction of cyano groups can improve the heat resistance of the resin composition, prepregs, laminates and metal foil-clad laminates.

The structure of the Formula (2) in the high-molecular-weight resin (D) contains an epoxy group, which can increase the curing strength of the high-molecular-weight resin (D) and the resin composition, thereby improving the heat resistance and humidity and heat resistance of the resin composition. For the content of epoxy groups, the content of the structure of Formula (2) in the high-molecular-weight resin (D) may be 0.01 to 0.20 (in terms of mole fraction). The epoxy value of the high-molecular-weight resin (D) is in the range of 0.10 eq/kg-0.80 eq/kg, preferably 0.35 eq/kg-0.70 eq/kg, further preferably 0.40 eq/kg-0.65 eq/kg. The epoxy value is the equivalent number of epoxy groups in 1 kg of high-molecular-weight resin (D). If the epoxy value is less than 0.10 eq/kg, the compatibility of the high-molecular-weight resin (D) in the resin composition decreases, and the heat resistance and the humidity and heat resistance of the resin composition, prepreg, laminate and metal foil-clad laminate will decrease. If the epoxy value is higher than 0.80 eq/kg, the high-molecular-weight resin (D) increases the crosslinking density of the resin composition, decreases the elasticity, and increases the modulus.

The structures of Formulae (2) and (3) in the high-molecular-weight resin (D) contains ester groups, and the structure of Formula (4) may contain an ester group. The ester group has strong hygroscopicity. However, the ester group in the structure of Formula (2) is connected to epoxidized glycidyl group; the ester group in the structure of Formula (4) contains a benzene ring structure, which both can improve the bonding strength of the resin composition. The cured product of the resin composition still has better resistance to humidity and heat when it absorbs moisture. Therefore, it can improve the humidity and heat resistance of the resin composition, prepreg, laminate and metal foil-clad laminate.

The high-molecular-weight resin (D) has a weight average molecular weight of 100,000 to 200,000. If the high-molecular-weight resin (D) has a weight average molecular weight of less than 100,000, the heat resistance of the high-molecular-weight resin (D) becomes poor; the prepreg becomes tacky, which affects storage and subsequent processing, so as to be difficult to achieve low elasticity and better heat and humidity resistance. If the high-molecular-weight resin (D) has a weight-average molecular weight of more than 200,000, the varnish liquid (class A state) of the resin composition has a too high viscosity, which affects the dispersion uniformity of the inorganic filler (E) in the resin composition and the wettability to the substrate. Meanwhile, there is a large difference in melt flowability between the high-molecular-weight resin (D) and other components of the resin composition, and the laminate (after curing) has a high-molecular-weight resin (D) resin layer.

The high-molecular-weight resin (D) is in an amount of 5 to 60% by mass of the total content 100% by mass of the epoxy resin (A), cyanate ester resin (B), and bismaleimide amine resin (C). If the high-molecular-weight resin (D) is in an amount of less than 5% by mass, it cannot form an effective or large continuous phase in the resin composition, nor can it play a role in lowering the modulus. If the high-molecular-weight resin (D) is in an amount of high than 60% by mass, the high-molecular-weight resin (D) cannot be uniformly dispersed in the resin composition, and the viscosity of the resin composition in the varnish state is too high to effectively impregnate the substrate.

When the high-molecular-weight resin (D) has a weight average molecular weight of less than 100,000 and a content of higher than 60% by mass, the uniform dispersion of the inorganic filler will not be affected due to low melt flowability of the high-molecular-weight resin (D) itself. When the high-molecular-weight resin (D) has a weight average molecular weight of higher than 200,000 and a content of less than 5% by mass, the uniform dispersion of the inorganic filler will be affected due to high melt flowability of the high-molecular-weight resin (D) itself.

### Inorganic filler (E)

The resin composition contains an inorganic filler (E), which can improve the heat resistance and humidity and heat resistance of the resin composition and the laminate, and can also improve the dimensional stability of the laminate and the metal foil-clad laminate and reduce the coefficient of thermal expansion of the same.

The type of the inorganic filler (E) is not limited, and may be any one or a mixture of at least two selected from the group consisting of crystalline silica, fused silica, amorphous silica, spherical silica, hollow silica, aluminum hydroxide, magnesium hydroxide, boehmite, molybdenum oxide, zinc molybdate, titanium dioxide, zinc oxide, boron nitride, aluminum nitride, silicon carbide, aluminum oxide, composite silicon fine powder, glass powder, short glass fiber or hollow glass. In order to make the resin composition have higher heat resistance, humidity and heat resistance and dimensional stability, it is preferably any one or a mixture of at least two selected from the group consisting of crystalline silica, fused silica, amorphous silica, spherical silica, hollow silica, aluminum hydroxide, magnesium hydroxide, boehmite, boron nitride, aluminum nitride, silicon carbide, aluminum oxide, composite silicon fine powder, glass powder, short glass fiber and hollow glass, further preferably spherical silica.

Optionally, the inorganic filler (E) is in amount of 10-300%, preferably 30-270%, further preferably 50-250%, by mass of the total content of the epoxy resin (A), cyanate ester resin (B) and bismaleimide resin (C).

In order to improve the compatibility of the inorganic filler (E) and the resin composition, a coupling agent may be added for surface treatment. The coupling agent is not limited, and it is generally selected from silane coupling agents. The type of silane coupling agent is not limited. Examples include epoxy silane coupling agents, amino silane coupling agents, vinyl silane coupling agents, styryl silane coupling agent, isobutylene silane coupling agent, acryl silane coupling agent, urea silane coupling agent, mercapto silane coupling agent, chloropropyl silane coupling agent, sulfide silane coupling agent, isocyanate-based silane coupling agent, etc.

### Accelerator (F) and other additives

In order to completely cure the resin composition, an accelerator (F) also needs to be added to the resin composition. The accelerator may be selected from curing accelerators that can accelerate the curing of cyanate ester resins and epoxy resins, specifically organic salts of metals such as copper, zinc, cobalt, nickel, manganese, imidazole and its derivatives, tertiary amines, etc. It can be used separately or in combination of two or more.

In addition, in order to make the resin composition have better processability and serviceability, various additives need to be added to the resin composition, which may be flame retardants, heat stabilizers, light stabilizers, antioxidants, lubricants, and the like.

The resin composition of the present invention can be prepared by dissolving, mixing, prepolymerizing, prereacting, stirring the epoxy resin (A), cyanate ester resin (B), bismaleimide resin (C), and high-molecular-weight resin (D). To dissolve the resin, an organic solvent needs to be used, as long as various resins can be completely dissolved without separation during mixing, such as methanol, ethanol, ethylene glycol, acetone, butanone, methyl ethyl ketone, cyclohexanone, toluene, xylene, N,N-dimethylformamide, N,N-dimethylacetamide, N-methyl-2-pyrrolidone, ethyl acetate and so son. One or more solvents can be used.

### -Prepreg, laminate, metal foil-clad laminate-

The prepreg of the present invention is formed of the resin composition of the present invention in a semi-cured state and a base material. Specifically, the prepreg is formed by a process in which a substrate is impregnated with the resin composition in a varnish state, and the resultant product is heated to volatilize the solvent and to convert into a semi-cured state.

The present invention has no particular limitation on the substrate, and it is usually woven fabric, non-woven fabric, roving, staple fiber, fiber paper, etc. The material may be inorganic fiber (for example, glass fibers such as E glass, D glass, L glass, M glass, S glass, T glass, NE glass, and quartz) or organic fibers (for example, polyimide, polyamide, polyester, polyphenylene ether, liquid crystal polymer, etc.), preferably glass fiber cloth.

The laminate of the present invention includes at least one sheet of the above prepreg.

The metal foil-clad laminate of the present invention includes at least one sheet of the above prepreg and a metal foil(s) coating on one or both sides of the prepreg(s). For example, metal foil-clad laminates can be manufactured by superimposing 1 to 20 sheets of prepreg and laminating with a configuration in which metal foils such as copper and aluminum are disposed on one or both sides.

### [Examples]

Hereinafter, the present invention will be described in detail using the examples.

### <Raw material of resin composition>

Epoxy resin (A1): Biphenyl aralkyl type epoxy resin ("NC-3000-H" manufactured by Nippon Kayaku Corporation, having the structure represented by Formula (5))
Epoxy resin (A2): naphthyl epoxy resin ("HP-6000" manufactured by DIC Corporation, having the structure shown in Formula (6)) 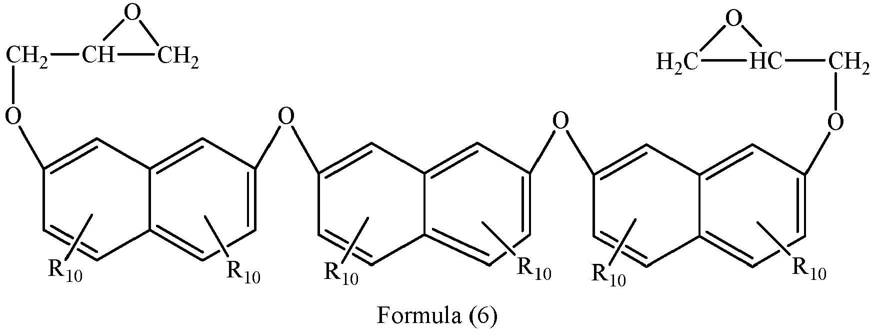 R₁₀ in Formula (6) is a hydrogen atom, methyl or ethyl.
Epoxy resin (A3): Bisphenol A type epoxy resin ("828US" manufactured by Mitsubishi Chemical Corporation)
Cyanate ester resin (B1): Bisphenol A type cyanate ester resin ("BA-3000S" manufactured by Lonza Corporation)
Cyanate ester resin (B2): Novolac cyanate ester resin ("PT-30S" manufactured by Lonza Corporation)
Bismaleimide resin (C1): bis(3-ethyl-5-methyl-4-bismaleimidophenyl)methane ("TY-2002" manufactured by Tianyi Chemical Company)
Bismaleimide resin (C2): Diphenylmethane type bismaleimide resin (made by Huading Polymer Synthetic Resin Co., Ltd.)
High-molecular-weight resin (D1): epoxy-modified acrylate resin ("PMS-22-1" manufactured by Nagase ChemteX, having a weight average molecular weight of 100,000 and an epoxy value of 0.63 eq/kg)
High-molecular-weight resin (D2): epoxy-modified acrylate resin ("PMS-22-1 to MW1" manufactured by Nagase ChemteX, having a weight average molecular weight of 200,000 and an epoxy value of 0.63 eq/kg)
High-molecular-weight resin (D3): epoxy-modified acrylate resin ("PMS-22-4" manufactured by Nagase ChemteX, having a weight average molecular weight of 100,000 and an epoxy value of 0.63 eq/kg)
High-molecular-weight resin (D4): epoxy-modified acrylate resin ("PMS-22-4 to MW1" manufactured by Nagase ChemteX, having a weight average molecular weight of 200,000 and an epoxy value of 0.63 eq/kg)
High-molecular-weight resin (D5): epoxy-modified acrylate resin ("PMS-19-5 to MW1" manufactured by Nagase ChemteX, having a weight average molecular weight of 100,000 and an epoxy value of 0.40 eq/kg)
High-molecular-weight resin (D6): epoxy-modified acrylate resin ("PMS-22-5" manufactured by Nagase ChemteX, having a weight average molecular weight of 100,000 and an epoxy value of 0.21 eq/kg)
wherein (D1)-(D6) have the structures represented by Formula (1), Formula (2), Formula (3) and Formula (4), k+l+m+n≤1; 0≤k≤0.30; 0.01<1≤0.20; 0.10≤m≤0.60; 00≤n≤0.60.
High-molecular-weight resin (D7): epoxy-modified acrylate resin ("PMS-22-5 to EP1" manufactured by Nagase ChemteX, having a weight average molecular weight of 100,000 and an epoxy value of 0.09 eq/kg), wherein (D7) has the structures represented by Formula (1), Formula (2), Formula (3) and Formula (4), but the epoxy value is less than 0.10 eq/kg.
High-molecular-weight resin (D8): epoxy-modified acrylate resin ("PMS-19-5" manufactured by Nagase ChemteX, having a weight average molecular weight of 700,000 and an epoxy value of 0.40 eq/kg), wherein (D8) has the structures represented by Formula (1), Formula (2), Formula (3) and Formula (4), but the weight average molecular weight is higher than 200,000.
Inorganic filler (E1): epoxy silane coupling agent modified spherical silica ("SC2050-MB" manufactured by Admatechs, D50: 0.5 µm)
Inorganic filler (E2): epoxy silane coupling agent modified boehmite ("BG-611" manufactured by Onestone Corporation, D50: 0.5-1.0 µm)
(F) accelerator
Organometallic salt accelerator: zinc octoate (manufactured by Shepchem, having the model name "BICATZ")
Imidazole accelerator: 2-ethyl-4-methylimidazole ("2E4MI" manufactured by Shikoku Chemicals Corporation)
Woven base material: glass fiber cloth (2116 glass fiber cloth made by Nittobo Corporation, single weight 104 g/m², thickness 92 µm)

In the examples and comparative examples of the present invention, each component is calculated as a solid.

### (Prepreg)

The epoxy resins (A1), (A2) and (A3), cyanate esters (B1) and (B2), bismaleimide (C1) and (C2), one of the high-molecular-weight resins (D1), (D2), (D3), (D4), (D5), (D6), (D7) and (D8), the inorganic fillers (E1) and (E2) and the accelerator (F) were blended according to the mass parts shown in Table 1 (Examples) or Table 2 (Comparative Examples), dissolved and diluted with dimethylformamide and butanone to prepare resin compositions in a varnish state.

Then, 2116 glass fiber cloth made by Nitto Spinning was impregnated with the resin compositions in a varnish state, heated and dried in a blast oven at 165 °C for 7 minutes to change the resin compositions in a varnish state to resin compositions in a semi-cured state, and control the thickness at 130-140 µm, thus producing prepregs.

### (Metal foil-clad laminate)

Two and eight sheets of the above-mentioned prepregs were laminated separately, and electrolytic copper foil with a thickness of 35 µm was laminated on both sides thereof, cured in a press for 2 hours with a curing pressure of 45 kg/cm² and a curing temperature of 240 °C, to obtain copper-clad laminates with a thickness of approximately 0.35 mm and 1.1 mm.

### (Laminate)

The metal foils of the metal foil-clad laminates were etched, to obtain laminates with a thickness of about 0.25 mm and 1.0 mm.

The laminates and metal foil-clad laminates prepared by using the resin composition of the present invention were tested for the heat resistance (Tg, T300), humidity and heat resistance and the coefficient of thermal expansion (CTE) in the plane direction. The test results are further illustrated and described in the following examples.

The test methods for the physical property data in Table 1 and Table 2 are as follows.

Glass transition temperature (Tg): Take a laminate with a length of 60 mm, a width of 8 to 12 mm, and a thickness of 1.0 mm as a sample, and measure it using a dynamic mechanical thermal analyzer (DMA) with a heating rate of 10 °C/min. The temperature at the peak of tanδ is taken as the result in °C .

T300 with copper: Take a metal foil-clad laminate with a length of 6.5 mm, a width of 6.5 mm, and a thickness of 1.1 mm as a sample. Bake the sample in an oven at 105 °C for 2 hours and then cooled to room temperature in a desiccator. Measure the sample using thermomechanical analysis (TMA). The temperature is increased at a heating rate of 10 °C/min from room temperature to 300 °C, and maintained at 300 °C for 10min. The time (in min) to delamination is determined as the time from the inflection point of the constant temperature to delamination. For the samples starting to delaminate at a temperature below 300 °C, record the temperature (in °C) at the beginning of delamination.

Coefficient of thermal expansion in the XY directions: Take a laminate with a length of 60 mm, a width of 4 mm, and a thickness of 0.25 mm as the sample. The glass fiber warp direction is X direction, and the glass fiber weft direction is Y direction. Bake the sample in an oven at 105 °C for 1 hour, and cool to room temperature in a desiccator. Thermomechanical analysis (TMA) is used for measurement. The temperature is raised from room temperature to 300 °C at a heating rate of 10 °C/min. The temperature is raised twice. After the first heating is completed and cooled to room temperature, the second temperature increase is carried out. The coefficient of thermal expansion in the planar direction from 50°C to 130°C in the second temperature rise is taken in ppm/°C.

Humidity and heat resistance: Take a laminate with a length of 50 mm, a width of 50 mm, and a thickness of 1.0 mm as a sample. Treat the sample with a high-pressure cooking tester at 121°C and two atmospheres for 2 h or 3 h, and then immerse the sample in a tin furnace at 288°C. Record the time without foaming. If it is more than 300s, the heat and humidity resistance will pass.

Peel strength: Take a metal foil-clad laminate with a length of 50 mm and a width of 50 mm as a sample, and use a tape or other methods to prepare a sample strip with a metal foil width of 3.0 mm by etching. Use a peeling resistance meter or other equivalent instruments to apply pressure in the vertical direction at a speed of 50 mm/min to peel the metal foil off the laminate, to obtain the peel strength of the metal-clad laminate with the unit of N/mm.

Bending modulus: Take a laminate with a length of 76.2 mm and a width of 25.4 mm as a sample, and measure it with a material testing machine, wherein the span is 25.4 mm, and the test speed is 0.76 mm/min. The maximum bending strength can be converted according to the formula to obtain bending modulus with the unit of Gpa.

Scanning Electron Microscope (SEM): Observe with a scanning electron microscope whether there is an interface in the cross-section of the laminate and whether the filler is uniformly dispersed. Sample pretreatment: A laminate is cut into small samples that are slightly smaller than the sample stage; the shear surface is smoothed by ion milling, etc.; then the oil stain on the shear surface is fully cleaned and fully dried; and finally, a metal layer of about 10nm, usually gold, is sprayed on the ground shear surface. Under high vacuum conditions, observe the morphology of the cross section of the laminate with a scanning electron microscope, and zoom in to observe the dispersion of the inorganic filler. If a resin layer containing no inorganic filler is observed between the wetting materials, it is judged that there is an interface; and if agglomeration in terms of dispersion or local unevenness in terms of distribution is observed for the filler, it is judged that the filler is not uniformly dispersed.

**[Table 1 (examples)]**

| | 1 | 2 | 3 | 4 | 5 | 6 | 7 | 8 | 9 | 10 | 11 | 12 | 13 | 14 | 15 |
|---|---|---|---|---|---|---|---|---|---|---|---|---|---|---|---|
| Mass parts of the blended materials | | | | | | | | | | | | | | | |
| A1 | 30 | 30 | 30 | 30 | 30 | 30 | 30 | 30 | 30 | | | | 30 | | 30 |
| A2 | 20 | 20 | 20 | 20 | 20 | 20 | 20 | 20 | 20 | 50 | | 40 | 20 | 70 | 20 |
| A3 | | | | | | | | | | | 50 | | | | |
| B1 | 30 | 30 | 30 | 30 | 30 | 30 | 30 | 30 | 30 | 30 | 30 | | 30 | | 30 |
| B2 | | | | | | | | | | | | 20 | | 20 | |
| C1 | 20 | 20 | 20 | 20 | 20 | 20 | 20 | 20 | 20 | 20 | 20 | | 20 | | 20 |
| C2 | | | | | | | | | | | | 40 | | 10 | |
| D1 | 30 | | | | | | 15 | 45 | 60 | 30 | 30 | | 65 | 30 | 30 |
| D2 | | 30 | | | | | | | | | | | | | |
| D3 | | | 30 | | | | | | | | | | | | |
| D4 | | | | 30 | | | | | | | | | | | |
| D5 | | | | | 30 | | | | | | | 30 | | | |
| D6 | | | | | | 30 | | | | | | | | | |
| E1 | 50 | 50 | 50 | 50 | 50 | 50 | 50 | 50 | 50 | 50 | 50 | | 30 | 15 0 | |
| E2 | | | | | | | | | | | | | | | 50 |
| Zinc octoate | 0.0 3 | 0.0 3 | 0.0 3 | 0.0 3 | 0.0 3 | 0.0 3 | 0.0 3 | 0.0 3 | 0.0 3 | 0.03 | 0.03 | 0.03 | 0.0 3 | 0.0 3 | 0.0 3 |
| 2E4MI | 0.1 5 | 0.1 5 | 0.1 5 | 0.1 5 | 0.1 5 | 0.1 5 | 0.1 5 | 0.1 5 | 0.1 5 | 0.15 | 0.15 | 0.15 | 0.1 5 | 0.1 5 | 0.1 5 |

| Physical property evaluation | | | | | | | | | | | | | | | |
|---|---|---|---|---|---|---|---|---|---|---|---|---|---|---|---|
| Tg (°C) | 27 3 | 27 3 | 27 3 | 27 3 | 27 7 | 27 7 | 27 3 | 27 3 | 27 3 | 278 | 250 | 285 | 273 | 24 0 | 27 3 |
| T300 with copper (min) | >6 0 | >6 0 | >6 0 | >6 0 | >6 0 | >6 0 | >6 0 | >6 0 | >6 0 | >60 | >60 | >60 | >60 | >6 0 | >6 0 |
| Coefficient of thermal expansion in X direction (ppm/°C) | 10 | 10 | 10 | 10 | 9 | 9 | 11 | 9 | 8 | 10 | 10 | 10 | 8 | 10 | 12 |
| Coefficient of thermal expansion in Y direction (ppm/°C) | 10 | 10 | 10 | 10 | 9 | 9 | 11 | 9 | 8 | 10 | 10 | 10 | 8 | 10 | 12 |
| Humidity and heat | 0/3 | 0/3 | 0/3 | 0/3 | 0/3 | 0/3 | 0/3 | 0/3 | 0/3 | 0/3 | 0/3 | 0/3 | 0/3 | 0/3 | 0/3 |
| resistance (2h) | | | | | | | | | | | | | | | |
| Humidity and heat resistance (3h) | 0/3 | 0/3 | 0/3 | 0/3 | 0/3 | 0/3 | 0/3 | 0/3 | 0/3 | 0/3 | 0/3 | 0/3 | 0/3 | 0/3 | 0/3 |
| Peel strength (N/mm) | 1.0 | 1.0 | 1.0 | 1.0 | 1.0 | 1.0 | 1.0 | 1.0 | 1.0 | 1.0 | 1.0 | 1.0 | 1.0 | 1.0 | 1.0 |
| Flexural modulus (GPa) | 16 | 16 | 16 | 16 | 16 | 16 | 18 | 14 | 12 | 16 | 16 | 12 | 12 | 20 | 15 |
| Interface in the laminate section | No | No | No | No | No | No | No | No | No | No | No | No | Minor interf ace | No | No |
| Uniform dispersion of the filler | Yes | Yes | Yes | Yes | Yes | Yes | Yes | Yes | Yes | Yes | Yes | Yes | Yes | Yes | Yes |

**[Table 2 (comparative examples)]**

| | 1 | 2 | 3 | 4 | 5 | 6 | 7 | 8 | 9 | 10 | 11 | 12 |
|---|---|---|---|---|---|---|---|---|---|---|---|---|
| Mass parts of the blended materials | | | | | | | | | | | | |
| A1 | 30 | 30 | 30 | 30 | 30 | 30 | 30 | 30 | 43 | 38 | 30 | 60 |
| A2 | 20 | 20 | 20 | 20 | 20 | 20 | 20 | 20 | 26 | 25 | 20 | 40 |
| B1 | 30 | 30 | 30 | 30 | 30 | 30 | 30 | 30 | 0 | 37 | 30 | |
| C1 | 20 | 20 | 20 | 20 | 20 | 20 | 20 | 20 | 31 | 0 | 20 | |
| D1 | | | | | | | | | 30 | 30 | | |
| D7 | 30 | | 15 | 45 | 60 | | | | | | 30 | |
| D8 | | 30 | | | | 15 | 60 | | | | | 30 |
| E1 | 50 | 50 | 50 | 50 | 50 | 50 | 50 | 50 | 50 | 50 | 350 | 30 |
| Zinc octoate | 0.03 | 0.03 | 0.03 | 0.03 | 0.03 | 0.03 | 0.03 | 0.03 | 0.03 | 0.03 | 0.03 | 0.03 |
| 2E4MI | 0.15 | 0.15 | 0.15 | 0.15 | 0.15 | 0.15 | 0.15 | 0.15 | 0.15 | 0.15 | 0.15 | 0.15 |

| Physical property evaluation | | | | | | | | | | | | |
|---|---|---|---|---|---|---|---|---|---|---|---|---|
| Tg (°C) | 270 | 273 | 270 | 270 | 270 | 273 | 273 | 260 | 280 | 220 | 273 | 200 |
| T300 with copper (min) | Delami nation below 300 °C | >60 | Delami nation below 300 °C | Delami nation below 300 °C | Delami nation below 300 °C | >60 | >60 | >60 | 26 | Delami nation below 300 °C | >60 | >60 |
| Coefficient of thermal expansion in X direction (ppm/°C) | 10 | 9 | 11 | 8 | 7 | 10 | 6 | 15 | 10 | 10 | 7 | 10 |
| Coefficient of thermal expansion in Y direction (ppm/°C) | 10 | 9 | 11 | 8 | 7 | 10 | 6 | 15 | 10 | 10 | 7 | 10 |
| Humidity and heat resistance (2h) | 3/3 | 0/3 | 3/3 | 3/3 | 3/3 | 0/3 | 3/3 | 0/3 | 1/3 | 3/3 | 3/3 | 0/3 |
| Humidity and heat resistance (3h) | 3/3 | 0/3 | 3/3 | 3/3 | 3/3 | 0/3 | 3/3 | 0/3 | 3/3 | 3/3 | 3/3 | 0/3 |
| Peel strength (N/mm) | 1.0 | 1.0 | 1.0 | 1.0 | 1.0 | 1.0 | 1.0 | 1.2 | 1.0 | 1.0 | 0.5 | 1.0 |
| Flexural modulus (GPa) | 16 | 16 | 18 | 14 | 12 | 16 | 16 | 25 | 20 | 16 | 34 | 16 |
| Interface in the laminate section | No | Yes | No | No | No | Yes | Yes | No | No | No | No | Yes |
| Uniform dispersion of the filler | Yes | No | Yes | Yes | Yes | No | No | Yes | Yes | Yes | Yes | No |

As can be seen from Tables 1 and 2, when the high-molecular-weight resin (D) has a too high weight average molecular weight (Comparative Example 2), the melt flowability of the high-molecular-weight resin (D) is poor; there is an interface in the SEM cross section of the laminate; and the uniform dispersion of the inorganic filler is affected. When the high-molecular-weight resin (D) has a too high content and a too high weight average molecular weight (Comparative Example 7), there is an interface in the SEM cross section of the laminate, and the uniform dispersion of the inorganic filler is affected. When the high-molecular-weight resin (D) has a too low molecular weight, or a too low content (Comparative Example 8), there is no increase effect on the Tg of the plate, and there is no effect of reducing the modulus and the CTE on the XY axis. When the structure of the high-molecular-weight resin (D) does not satisfy k+l+m+n≤1, 0≤k≤0.30, 0.01<1≤0.20, 0.10≤m≤0.60, 0≤n≤0.60 (Comparative Examples 1, 3-5 and 11), the heat resistance and the humidity and heat resistance of the laminate will be affected. When the resin composition contains no cyanate ester or maleimide (Comparative Examples 9 and 10), the heat resistance and the humidity and heat resistance of the laminate will be affected.

The resin composition of the present invention contains the high-molecular-weight resin (D) having structures represented by Formula (1), (2), (3) and (4) and a weight average molecular weight of 100,000 to 200,000, wherein k, l, m and n are molar fractions; and k+l+m+n≤1, 0≤k≤0.30, 0.01<1≤0.20, 0.10≤m≤0.60, 0≤n≤0.60 and an epoxy value of the high-molecular-weight resin (D) in the range of 0.10 eq/kg to 0.80 eq/kg. Therefore, the Tg of the laminate can be improved, and the coefficient of thermal expansion of the laminate in the XY directions can be effectively reduced, and at the same time, the modulus can be reduced, without affecting the high heat resistance and the humidity and heat resistance of the laminate. When the resin composition is used as a prepreg, the stress generated by chip elements and printed circuit boards due to difference in thermal expansion upon soldering and heating is relaxed, so that the solder cracks that are likely to be generated at the joint portion are reduced.

The above-mentioned embodiments are not intended to limit the content of the composition of the present invention. Therefore, any minor modification, equivalent changes or modifications made according to the technical essences or the weight parts or content of the composition described in the present invention still fall within the scope of the technical solutions of the present invention.

The applicant claims that the detailed compositions of the present invention are described by the above embodiments. However, the present invention is not limited to the detailed structural features above, *i.e.* it does not mean that the present invention cannot be carried out unless the above embodiments are applied. Those skilled in the art shall know that any modifications of the present invention, equivalent substitutions of the materials selected for use in the present invention, and addition of the auxiliary ingredients, and specific manner in which they are selected, all are within the protection scope and disclosure of the present invention.

## Claims

1. A resin composition, containing an epoxy resin (A), a cyanate ester resin (B), a bismaleimide resin (C), a high-molecular-weight resin (D) having structures represented by Formula (1), Formula (2), Formula (3) and Formula (4) and a weight-average molecular weight of 100,000 to 200,000, and an inorganic filler (E), 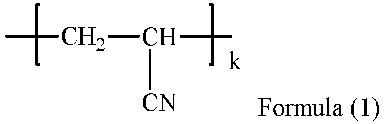 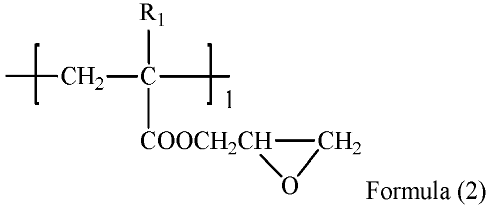 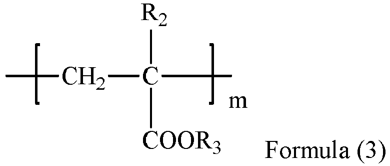 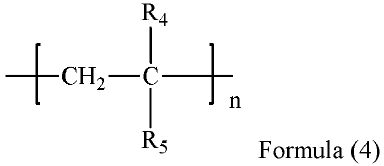
wherein k, l, m and n are molar fractions, where k + l + m + n≤1; 0≤k≤0.30; 0.01≤l≤0.20; 0.10≤m≤0.60; 0≤n≤0.60; in Formula (2), R₁ is a hydrogen atom or an alkyl group having 1-8 carbon atoms; in Formula (3), R₂ and R₃ are each independently a hydrogen atom or an alkyl group having 1-8 carbon atoms; in Formula (4), R₄ is a hydrogen atom or an alkyl group having 1-8 carbon atoms; R₅ is Ph (phenyl), -COO(CH₂)₂Ph or -COOCH₂Ph;
wherein the epoxy value of the high-molecular-weight resin (D) is in the range of 0.10 eq/kg to 0.80 eq/kg.

2. The resin composition according to claim 1, wherein R₁ is a hydrogen atom or a methyl group; R₂ is a hydrogen atom or a methyl group; R₃ is an alkyl group having 1-8 carbon atoms; R₄ is a hydrogen atom or a methyl group.

3. The resin composition according to claim 1 or 2, wherein the high-molecular-weight resin (D) is in an amount of 5 to 60% by mass of the total content 100% by mass of the epoxy resin (A), cyanate ester resin (B) and bismaleimide amine resin (C).

4. The resin composition according to any one of claims 1 to 3, wherein the epoxy value of the high-molecular-weight resin (D) is in the range of 0.35 eq/kg to 0.70 eq/kg; further preferably, the epoxy value of the high-molecular-weight resin (D) is in the range of 0.40 eq/kg to 0.65 eq/kg.

5. The resin composition according to any one of claims 1 to 4, wherein the epoxy resin (A) is in an amount of 20 to 80%, preferably 30 to 70%, further preferably 40 to 60%, by mass of the total content 100% by mass of the epoxy resin (A), cyanate ester resin (B), and bismaleimide amine resin (C).

6. The resin composition according to any one of claims 1 to 5, wherein the cyanate ester resin (B) is in an amount of 15 to 70%, preferably 20 to 60%, further preferably 20 to 50%, by mass of the total content 100% by mass of the epoxy resin (A), cyanate ester resin (B), and bismaleimide amine resin (C).

7. The resin composition according to any one of claims 1 to 6, wherein the bismaleimide amine resin (C) is in an amount of 5 to 50%, preferably 10 to 40%, by mass of the total content 100% by mass of the epoxy resin (A), cyanate ester resin (B), and bismaleimide amine resin (C).

8. The resin composition according to any one of claims 1 to 7, wherein the inorganic filler (E) is in an amount of 10 to 300%, preferably 30 to 270%, further preferably 50 to 250%, by mass of the total content 100% by mass of the epoxy resin (A), cyanate ester resin (B), and bismaleimide amine resin (C).

9. A prepreg, comprising a substrate and the resin composition according to any one of claims 1 to 8 attached thereon by impregnation or coating.

10. A laminate, comprising at least one prepreg according to claim 9.

11. A metal foil-clad laminate, comprising at least one prepreg according to claim 9 and a metal foil(s) coated on one or both sides of the prepreg(s).

## Patentansprüche

1. Harzzusammensetzung, die ein Epoxidharz (A), ein Cyanatesterharz (B), ein Bismaleimidharz (C), ein Harz (D) mit hohem Molekulargewicht, das Strukturen aufweist, die durch Formel (1), Formel (2), Formel (3) und Formel (4), und ein gewichtsmittleres Molekulargewicht von 100.000 bis 200.000 dargestellt werden, und einen anorganischen Füllstoff (E) enthält, 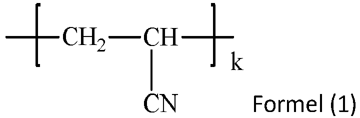 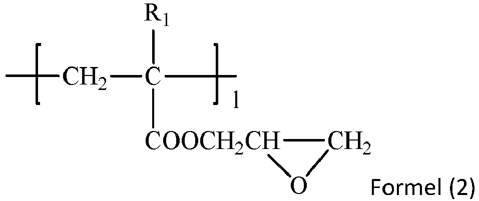 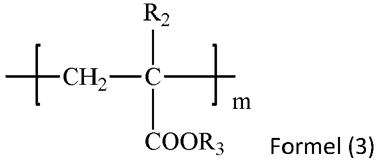 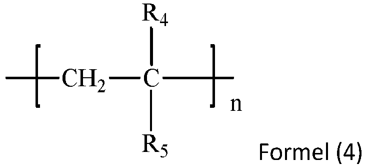
wobei k, 1, m und n Molfraktionen sind, wobei k + 1 + m + n≤1; 0≤k≤0,30; 0,01 ≤ l ≤ 0,20; 0,10 ≤ m ≤ 0,60; 0≤n≤0,60; in Formel (2) R₁ ein Wasserstoffatom oder eine Alkylgruppe ist, die 1-8 Kohlenstoffatome aufweist; in Formel (3) R₂ und R₃ jeweils unabhängig voneinander ein Wasserstoffatom oder eine Alkylgruppe ist, die 1-8 Kohlenstoffatome aufweist; in Formel (4) R₄ ein Wasserstoffatom oder eine Alkylgruppe ist, die 1-8 Kohlenstoffatome aufweist; R₅ Ph (Phenyl), -COO(CH₂)₂Ph oder -COOCH₂Ph ist;
wobei der Epoxidwert des Harzes (D) mit dem hohen Molekulargewicht im Bereich von 0,10 val/kg bis 0,80 val/kg liegt.

2. Harzzusammensetzung nach Anspruch 1, wobei R₁ ein Wasserstoffatom oder eine Methylgruppe ist; R₂ ein Wasserstoffatom oder eine Methylgruppe ist; R₃ eine Alkylgruppe ist, die 1-8 Kohlenstoffatome aufweist; R₄ ein Wasserstoffatom oder eine Methylgruppe ist.

3. Harzzusammensetzung nach Anspruch 1 oder 2, wobei das Harz (D) mit hohem Molekulargewicht in einer Menge von 5 bis 60 Masse-% des Gesamtgehalts von 100 Masse-% des Epoxidharzes (A), Cyanatesterharzes (B) und Bismaleimidaminharzes (C) vorliegt.

4. Harzzusammensetzung nach einem der Ansprüche 1 bis 3, wobei der Epoxidwert des Harzes (D) mit hohem Molekulargewicht im Bereich von 0,35 val/kg bis 0,70 val/kg liegt; weiter bevorzugt der Epoxidwert des Harzes (D) mit hohem Molekulargewicht im Bereich von 0,40 val/kg bis 0,65 val/kg liegt.

5. Harzzusammensetzung nach einem der Ansprüche 1 bis 4, wobei das Epoxidharz (A) in einer Menge von 20 bis 80 Masse-%, bevorzugt 30 bis 70 Masse-%, weiter bevorzugt 40 bis 60 Masse-% des Gesamtgehalts von 100 Masse-% des Epoxidharzes (A), Cyanatesterharzes (B) und Bismaleimidaminharzes (C) vorliegt.

6. Harzzusammensetzung nach einem der Ansprüche 1 bis 5, wobei das Cyanatesterharz (B) in einer Menge von 15 bis 70 Masse-%, bevorzugt 20 bis 60 Masse-%, weiter bevorzugt 20 bis 50 Masse-% des Gesamtgehalts von 100 Masse-% des Epoxidharzes (A), Cyanatesterharzes (B) und Bismaleimidaminharzes (C) vorliegt.

7. Harzzusammensetzung nach einem der Ansprüche 1 bis 6, wobei das Bismaleimidaminharz (C) in einer Menge von 5 bis 50 Masse-%, bevorzugt 10 bis 40 Masse-% des Gesamtgehalts von 100 Masse-% des Epoxidharzes (A), des Cyanatesterharzes (B) und des Bismaleimidaminharzes (C) vorliegt.

8. Harzzusammensetzung nach einem der Ansprüche 1 bis 7, wobei der anorganische Füllstoff (E) in einer Menge von 10 bis 300 Masse-%, bevorzugt 30 bis 270 Masse-%, weiter bevorzugt 50 bis 250 Masse-% des Gesamtgehalts von 100 Masse-% des Epoxidharzes (A), des Cyanatesterharzes (B) und des Bismaleimidaminharzes (C) vorliegt.

9. Prepreg, das ein Substrat und die Harzzusammensetzung nach einem der Ansprüche 1 bis 8 umfasst, die auf diesem durch Imprägnierung oder Beschichtung befestigt ist.

10. Laminat, das mindestens ein Prepreg nach Anspruch 9 umfasst.

11. Metallfolienkaschiertes Laminat, das mindestens ein Prepreg nach Anspruch 9 und eine oder mehrere Metallfolie(n), die auf eine oder beide Seiten des/der Prepregs aufgetragen sind, umfasst.

## Revendications

1. Composition de résines, contenant une résine époxy (A), une résine d'ester de cyanate (B), une résine de bismaléimide (C), une résine à poids moléculaire élevé (D) présentant des structures représentées par la Formule (1), la Formule (2), la Formule (3) et la Formule (4) et un poids moléculaire moyen en poids de 100 000 à 200 000, et une charge inorganique (E), 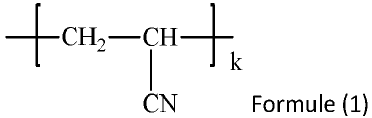 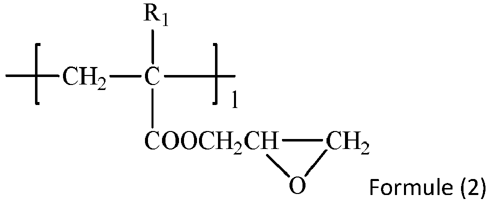 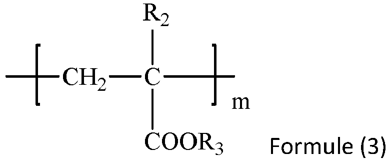 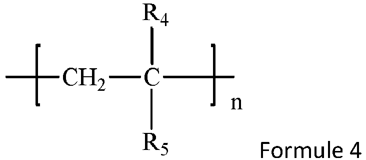
dans laquelle k, l, m et n sont des fractions molaires, où k + l + m + n≤1 ; 0≤k≤0,30 ; 0,01≤l≤0,20 ; 0,10≤m≤0,60 ; 0≤n≤0,60 ; dans la Formule (2), R₁ est un atome d'hydrogène ou un groupe alkyle présentant de 1-8 atomes de carbone ; dans la formule (3), R₂ et R₃ représentent chacun indépendamment un atome d'hydrogène ou un groupe alkyle présentant de 1-8 atomes de carbone ; dans la formule (4), R₄ est un atome d'hydrogène ou un groupe alkyle présentant de 1-8 atomes de carbone ; R₅ est Ph (phényle), - COO(CH₂)₂Ph ou -COOCH₂Ph ;
dans laquelle l'indice d'époxy de la résine à poids moléculaire élevé (D) est dans la plage de 0,10 eq/kg à 0,80 eq/kg.

2. Composition de résines selon la revendication 1, dans laquelle R₁ est un atome d'hydrogène ou un groupe méthyle ; R₂ est un atome d'hydrogène ou un groupe méthyle ; R₃ est un groupe alkyle présentant de 1-8 atomes de carbone ; R₄ est un atome d'hydrogène ou un groupe méthyle.

3. Composition de résines selon la revendication 1 ou 2, dans laquelle la résine à poids moléculaire élevé (D) est présente en une quantité de 5 à 60 % en masse de la teneur totale de 100 % en masse de la résine époxy (A), de la résine d'ester de cyanate (B) et de la résine de bismaléimide amine (C).

4. Composition de résines selon l'une quelconque des revendications 1 à 3, dans laquelle l'indice d'époxy de la résine à poids moléculaire élevé (D) est dans la plage de 0,35 eq/kg à 0,70 eq/kg ; de préférence encore, l'indice d'époxy de la résine à poids moléculaire élevé (D) est dans la plage allant de 0,40 eq/kg à 0,65 eq/kg.

5. Composition de résines selon l'une quelconque des revendications 1 à 4, dans laquelle la résine époxy (A) est présente en une quantité de 20 à 80 %, de préférence de 30 à 70 %, de préférence encore de 40 à 60 %, en masse de la teneur totale de 100 % en masse de la résine époxy (A), de la résine d'ester cyanate (B) et de la résine de bismaléimide amine (C).

6. Composition de résines selon l'une quelconque des revendications 1 à 5, dans laquelle la résine d'ester de cyanate (B) est présente en une quantité de 15 à 70 %, de préférence de 20 à 60 %, de préférence encore de 20 à 50 % en masse de la teneur totale de 100 % en masse de la résine époxy (A), de la résine d'ester de cyanate (B) et de la résine de bismaléimide amine (C).

7. Composition de résines selon l'une quelconque des revendications 1 à 6, dans laquelle la résine de bismaléimide amine (C) est présente en une quantité de 5 à 50 %, de préférence de 10 à 40 %, en masse de la teneur totale de 100 % en masse de la résine époxy (A), de la résine d'ester de cyanate (B) et de la résine de bismaléimide amine (C).

8. Composition de résines selon l'une quelconque des revendications 1 à 7, dans laquelle la charge inorganique (E) est présente en quantité de 10 à 300 %, de préférence de 30 à 270 %, de préférence encore de 50 à 250 %, en masse de la teneur totale de 100 % en masse de la résine époxy (A), de la résine d'ester de cyanate (B) et de la résine de bismaléimide amine (C).

9. Préimprégné, comprenant un substrat et la composition de résines selon l'une quelconque des revendications 1 à 8 fixée dessus par imprégnation ou application en revêtement.

10. Stratifié comprenant au moins un préimprégné selon la revendication 9.

11. Stratifié recouvert d'une feuille métallique, comprenant au moins un préimprégné selon la revendication 9 et une ou plusieurs feuilles métalliques appliquées en revêtement sur une ou les deux faces du ou des préimprégnés.
